# EUROPEAN PATENT APPLICATION

(11) **EP 4 203 649 A1**
(43) Date of publication of application: **28.06.2023**
(21) Application number: 22203411.8
(22) Date of filing: 24.10.2022
(51) Int. Cl.: H10K 50/19, H10K 50/16, H10K 50/15

(54) **ELECTROLUMINESCENT DISPLAY DEVICE**

(30) Priority: 23.12.2021 KR 20210185853
(71) Applicant: LG Display Co., Ltd., SEOUL, 07336 (KR)
(72) Inventor: KIM, Boseong, 10845 Paju-si (KR); YOO, Namseok, 10845 Paju-si (KR); KIM, KwangJong, 10845 Paju-si (KR)
(74) Representative: Cousens, Nico

(57) **Abstract**

Disclosed is an electroluminescent display device comprising a first electrode and a second electrode, a first stack including a first emission layer between the first electrode and the second electrode, a second stack including a second emission layer between the first stack and the second electrode, and a charge generation layer including a first N-type charge generation layer and a first P-type charge generation layer between the first stack and the second stack, wherein the second stack includes a second N-type charge generation layer, a second P-type charge generation layer, and a third N-type charge generation layer sequentially stacked between the second emission layer and the second electrode.

## Description

### CROSS-REFERENCE TO RELATED APPLICATIONS

This application claims the benefit of the Korean Patent Application No. 10-2021-0185853 filed on December 23, 2021.

### BACKGROUND

### Technical Field

The present disclosure relates to an electroluminescent display device.

### Description of the Related art

An electroluminescent display device includes a first electrode, a second electrode, and a light emitting layer provided between the first electrode and the second electrode, wherein the light emitting layer emits light by an electric field between the two electrodes, thereby displaying an image.

The light emitting layer may include an organic material that emits light as an exciton is generated by a combination of electron and hole, and the generated exciton falls from an excited state to a ground state.

If a change in characteristics of the electroluminescent display device becomes large according to a temperature change, it is difficult to apply the electroluminescent display device to various technical fields.

For example, in the case of the related art electroluminescence display device, it has a problem related with a deterioration of temperature luminance sensitivity TLS characteristic.

That is, in a room temperature environment, there is almost no change in luminance of the electroluminescent display device. However, in a high and low-temperature environment, the electroluminescent display device has a problem related with a large luminance change.

### SUMMARY

The present disclosure has been made in view of the above problems, and it is an object of the present disclosure to provide an electroluminescent display device with a small luminance change even in a high and low temperature environments.

An invention is defined in the independent claims. In accordance with an aspect of the present disclosure, the above and other objects can be accomplished by the provision of an electroluminescent display device comprising: a first electrode and a second electrode; a first emission layer between the first electrode and the second electrode; a charge generation layer including a first N-type charge generation layer and a first P-type charge generation layer above the first emission layer; and a second N-type charge generation layer between the first P-type charge generation layer and the second electrode.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a graph showing changes in the characteristics of a temperature luminance sensitivity TLS according to a capacitance reduction amount for each subpixel;
FIG. 2 is a cross sectional view schematically illustrating an electroluminescent display device according to one embodiment of the present disclosure;
FIG. 3 is a cross sectional view schematically illustrating an electroluminescent display device according to another embodiment of the present disclosure;
FIG. 4 is a cross sectional view schematically illustrating an electroluminescent display device according to another embodiment of the present disclosure;
FIG. 5 is a cross sectional view schematically illustrating an electroluminescent display device according to another embodiment of the present disclosure;
FIG. 6a and 6b illustrate a current density-voltage curve in Comparative Examples 1 to 3 and Embodiments 1 and 2;
FIG. 7 illustrates a capacitance-voltage curve in Comparative Examples 1 to 3 and Embodiments 1 and 2; and
FIG. 8a and 8b illustrate a current density-voltage curve according to a thickness change in a second N-type charge generation layer, a second P-type charge generation layer, and a third N-type charge generation layer in the Embodiment 1.

### DETAILED DESCRIPTION DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference signs refer to like elements throughout. In the following description, when the detailed description of the relevant known function or configuration is determined to unnecessarily obscure the important point of the present disclosure, the detailed description will be omitted.

In construing an element, the element is construed as including an error range although there is no explicit description.

In describing a position relationship, for example, when a position relation between two parts is described as 'on∼', 'over∼', 'under~', and 'next∼', one or more other parts may be disposed between the two parts unless 'just' or 'direct' is used.

In describing a time relationship, for example, when the temporal order is described as 'after∼', 'subsequent∼', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, preferred embodiments of the present disclosure will be described in detail with reference to the accompanying drawings.

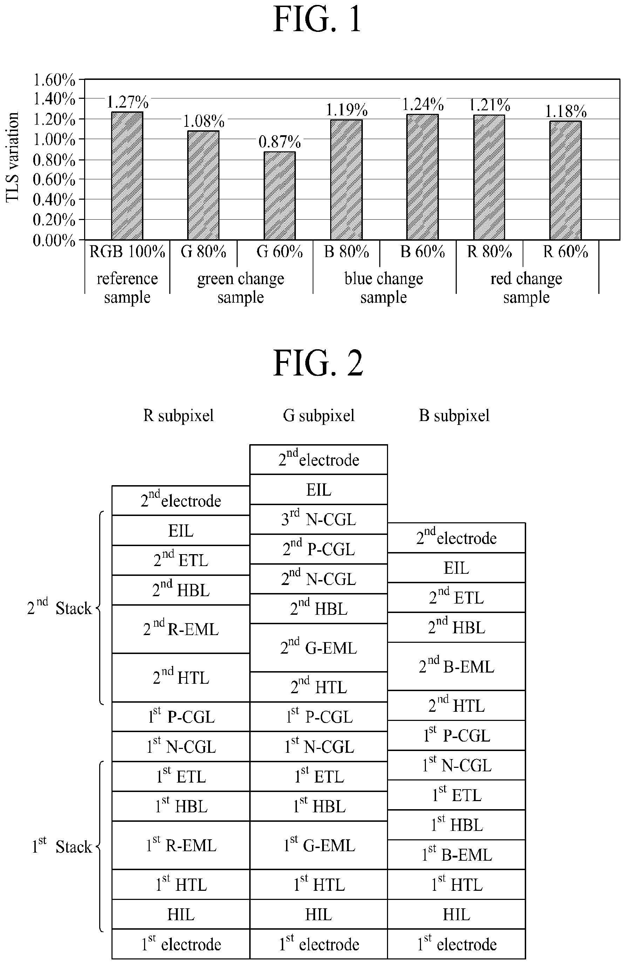

In order to overcome a problem related with a luminance change in an electroluminescent display device according to a temperature change, various experiments are studied. As a result, a luminance variation according to a temperature change is reduced when a capacitance between a first electrode and a second electrode is reduced in the electroluminescent display device. This will be described with reference to FIG. 1.

FIG. 1 is a graph showing changes in the characteristics of a temperature luminance sensitivity TLS according to a capacitance reduction amount for each subpixel.

In FIG. 1, a vertical axis represents a temperature luminance sensitivity TLS variation, and '0.00%' indicates that there is no change in the temperature luminance sensitivity TLS variation.

In a horizontal axis of FIG. 1, a reference sample corresponds to a sample assumed to have a capacitance between subpixel electrodes of 100% of a reference capacitance value in a red R subpixel, a green G subpixel, and a blue B subpixel of the reference sample.

In the horizontal axis of FIG. 1, a green change sample corresponds to a sample assumed to have 100% of the reference capacitance value in each of its red R subpixel and blue B subpixel and to have 80% or 60% of the reference capacitance value in its green G subpixel as compared with the reference sample.

In the horizontal axis of FIG. 1, a blue change sample corresponds to a sample assumed to have 100% of the reference capacitance value in each of its red R subpixel and green G subpixel and to have 80% or 60% of the reference capacitance value in its blue B subpixel as compared with the reference sample.

In the horizontal axis of FIG. 1, a red change sample corresponds to a sample assumed to have 100% of the reference capacitance value in each of its green G subpixel and blue B subpixel and to have 80% or 60% of the reference capacitance value in the red R subpixel as compared with the reference sample.

As shown in FIG. 1, in the case of the reference sample, a change of temperature luminance sensitivity TLS is 1.27%, which is very high.

On the other hand, in the case of the green change sample, a change of temperature luminance sensitivity TLS is 1.08% and 0.87%, respectively, which is considerably reduced as compared to the reference sample.

In addition, in the case of the blue change sample, a change of temperature luminance sensitivity TLS is 1.19% and 1.24%, respectively, which is somewhat reduced as compared to the reference sample. However, in comparison to the green change sample, the change of the blue change sample is not reduced as much.

Also, in the case of the red change sample, a change of temperature luminance sensitivity TLS is 1.21% and 1.18%, respectively, which is somewhat reduced as compared to the reference sample. However, in comparison to the green change sample, the change of the red change sample is not reduced as much.

In summary, as shown in FIG. 1, in comparison to the reduction of capacitance in the red R subpixel or the blue B subpixel, the reduction of capacitance in the green G subpixel is more favorable to the reduction of change in the temperature luminance sensitivity TLS.

Therefore, according to one embodiment of the present disclosure, the capacitance of the green G subpixel may be reduced to lower the change of the temperature luminance sensitivity TLS in the electroluminescent display device, and a configuration of increasing a thickness of the green G subpixel may be provided to reduce the capacitance of the green G subpixel, but not limited to this method.

Hereinafter, various embodiments of the present disclosure for increasing the thickness of the green G subpixel will be described.

FIG. 2 is a cross sectional view schematically illustrating an electroluminescent display device according to one embodiment of the present disclosure.

As shown in FIG. 2, the electroluminescent display device according to one embodiment of the present disclosure includes a red R subpixel, a green G subpixel, and a blue B subpixel.

Each of the red R subpixel, the green G subpixel, and the blue B subpixel may include a first electrode 1^{st} electrode, a second electrode 2^{nd} electrode, and a first stack 1^{st} stack, a first charge generation layer 1^{st} N-CGL and 1^{st} P-CGL and a second stack 2^{nd} stack which are sequentially stacked between the first electrode 1^{st} electrode and the second electrode 2^{nd} electrode.

The first electrode 1^{st} electrode may function as an anode of the electroluminescent display device, and may be patterned to be separated from each of the red R, green G, and blue B subpixels.

The second electrode 2^{nd} electrode may function as a cathode of the electroluminescent display device, and may be formed as a continuous common electrode without being separated from the red R, green G, and blue B subpixels.

If the electroluminescent display device according to one embodiment of the present disclosure is a top emission type, the first electrode 1^{st} electrode includes a reflective electrode, and the second electrode 2^{nd} electrode may include a transparent electrode or a semi-transparent electrode. Alternatively, if the electroluminescent display device according to one embodiment of the present disclosure is a bottom emission type, the first electrode 1^{st} electrode may include a transparent electrode or a semi-transparent electrode, and the second electrode 2^{nd} electrode may include a reflective electrode.

The first stack 1^{st} stack of the red R subpixel may include a hole injection layer HIL, a first hole transporting layer 1^{st} HTL, a first red emission layer 1^{st} R-EML, a first hole blocking layer 1^{st} HBL, and a first electron transporting layer 1^{st} ETL.

The first stack 1^{st} stack of the green G subpixel may include a hole injection layer HIL, a first hole transporting layer 1^{st} HTL, a first green emission layer 1^{st} G-EML, a first hole blocking layer 1^{st} HBL, and a first electron transporting layer 1^{st} ETL.

The first stack 1^{st} stack of the blue B subpixel may include a hole injection layer HIL, a first hole transporting layer 1^{st} HTL, a first blue emission layer 1^{st} B-EML, a first hole blocking layer 1^{st} HBL, and a first electron transporting layer 1^{st} ETL.

The hole injection layer HIL may be formed between the first electrode 1^{st} electrode and the first hole transporting layer 1^{st} HTL, and may be formed of the same material at the same thickness in each of the red R, green G, and blue B subpixels, but is not limited thereto. The hole injection layer HIL may be formed of various materials generally known to those in the art.

The first hole transporting layer 1^{st} HTL may be formed between the hole injection layer HIL and the first red / green / blue emission layers 1^{st} R- EML / 1^{st} G-EML / 1^{st} B-EML and may be formed of the same material at the same thickness in each of the red R, green G, and blue B subpixels, but is not limited thereto. For example, in order to realize the micro-cavity characteristic, the thickness of the first hole transporting layer 1^{st} HTL of the red R subpixel may be larger than the thickness of the first hole transporting layer 1^{st} HTL of the green G subpixel, and the thickness of the first hole transporting layer 1^{st} HTL of the green G subpixel may be larger than the thickness of the first hole transporting layer 1^{st} HTL of the blue B subpixel. The first hole transporting layer 1^{st} HTL may be formed of various materials generally known to those in the art.

Each of the first red / green / blue emission layers 1^{st} R-EML / 1^{st} G-EML / 1^{st} B-EML is provided between the first hole transporting layer 1^{st} HTL and the first hole blocking layer 1^{st} HBL. In order to realize the micro-cavity characteristic, the thickness of the first blue emission layer 1^{st} B-EML may be smaller than that of the first red emission layer 1^{st} R-EML and the first green emission layer 1^{st} G-EML, but is not limited thereto. Each of the first red / green / blue emission layers 1^{st} R-EML / 1^{st} G-EML / 1^{st} B-EML may be formed of various materials generally known to those in the art.

The first hole blocking layer 1^{st} HBL may be formed between the first red / green / blue emission layers 1^{st} R-EML / 1^{st} G-EML / 1^{st} B-EML and the first electron transporting layer 1^{st} ETL, and may be formed of the same material at the same thickness in the red R, green G, and blue B subpixels, but is not limited thereto. The first hole blocking layer 1^{st} HBL may be formed of various materials generally known to those in the art.

The first electron transporting layer 1^{st} ETL may be formed between the first hole blocking layer 1^{st} HBL and the first N-type charge generation layer 1^{st} N-CGL and may be formed of the same material at the same thickness in the red R, green G, and blue B subpixels, but is not limited thereto. The first electron transporting layer 1^{st} ETL may be formed of various materials generally known to those in the art.

Any one of the first hole blocking layer 1^{st} HBL and the first electron transporting layer 1^{st} ETL may be omitted.

In each of the red R, green G, and blue B subpixels, the first charge generation layer 1^{st} N-CGL and 1^{st} P-CGL includes the first N-type charge generation layer 1^{st} N-CGL and the first P-type charge generation layer 1^{st} P-CGL provided between the first stack 1^{st} stack and the second stack 2^{nd} stack.

The first N-type charge generation layer 1^{st} N-CGL is provided between the first electron transporting layer 1^{st} ETL and the first P-type charge generation layer 1^{st} P-CGL to supply electrons to the first stack 1^{st} stack. The first N-type charge generation layer 1^{st} N-CGL may be formed of the same material at the same thickness in the red R, green G, and blue B subpixels, but is not limited thereto. The first N-type charge generation layer 1^{st} N-CGL may be formed of various materials generally known to those in the art.

The first P-type charge generation layer 1^{st} P-CGL is provided between the first N-type charge generation layer 1^{st} N-CGL and the second stack 2^{nd} stack to supply holes to the second stack 2^{nd} stack. The first P-type charge generation layer 1^{st} P-CGL may be formed of the same material at the same thickness in the red R, green G, and blue B subpixels, but is not limited thereto. The first P-type charge generation layer 1^{st} P-CGL may be formed of various materials generally known to those in the art.

The second stack 2^{nd} stack of the red R subpixel may include a second hole transporting layer 2^{nd} HTL, a second red emission layer 2^{nd} R-EML, a second hole blocking layer 2^{nd} HBL, a second electron transporting layer 2^{nd} ETL, and an electron injection layer EIL.

The second stack 2^{nd} stack of the green G subpixel includes a second hole transporting layer 2^{nd} HTL, a second green emission layer 2^{nd} G-EML, a second hole blocking layer 2^{nd} HBL, a second N-type charge generation layer 2^{nd} N-CGL, a second P-type charge generation layer 2^{nd} P-CGL, a third N-type charge generation layer 3^{rd} N-CGL, and an electron injection layer EIL.

The second stack 2^{nd} stack of the blue B subpixel may include a second hole transporting layer 2^{nd} HTL, a second blue emission layer 2^{nd} B-EML, a second hole blocking layer 2^{nd} HBL, a second electron transporting layer 2^{nd} ETL, and an electron injection layer EIL.

The second hole transporting layer 2^{nd} HTL may be formed between the first P-type charge generation layer 1^{st} P-CGL and the second red / green / blue emission layers 2^{nd} R-EML / 2^{nd} G-EML / 2^{nd} B-EML, and the second hole transporting layer 2^{nd} HTL may be formed of the same material at the same thickness in the red R, green G, and blue B subpixels, but is not limited thereto. For example, in order to realize the micro-cavity characteristic, the thickness of the second hole transporting layer 2^{nd} HTL of the red R subpixel may be larger than the thickness of the second hole transporting layer 2^{nd} HTL of the green G subpixel, and the thickness of the second hole transporting layer 2^{nd} HTL of the green G subpixel may be larger than the thickness of the second hole transporting layer 2^{nd} HTL of the blue B subpixel. The second hole transporting layer 2^{nd} HTL may be formed of various materials generally known to those in the art.

Each of the second red / green / blue emission layers 2^{nd} R-EML / 2^{nd} G-EML / 2^{nd} B-EML is provided between the second hole transporting layer 2^{nd} HTL and the second hole blocking layer 2^{nd} HBL. In order to realize the micro-cavity characteristic, the thickness of the second blue emission layer 2^{nd} B-EML may be smaller than each of the thickness of the second red emission layer 2^{nd} R-EML and the thickness of the second green emission layer 2^{nd} G-EML, but is not limited thereto. Each of the second red / green / blue emission layers 2^{nd} R-EML / 2^{nd} G-EML / 2^{nd} B-EML may be formed of various materials generally known to those in the art.

The thickness difference of the second hole transporting layer 2^{nd} HTL between each of the red R, green G and blue B subpixels may occur, and the thickness difference between each of the second red / green / blue emission layers 2^{nd} R-EML / 2^{nd} G-EML / 2^{nd} B-EML may occur. As a result, the distance from the first electrode 1^{st} electrode of the red R subpixel to the second red emission layer 2^{nd} R-EML may be longer than the distance from the first electrode 1^{st} electrode of the green G subpixel to the second green emission layer 2^{nd} G-EML. In addition, the distance from the first electrode 1^{st} electrode of the green G subpixel to the second green emission layer 2^{nd} G-EML may be longer than the distance from the first electrode 1^{st} electrode of the blue B subpixel to the second blue emission layer 2^{nd} G-EML.

The second hole blocking layer 2^{nd} HBL is provided between the second red / blue emission layers 2^{nd} R-EML / 2^{nd} B-EML and the second electron transporting layer 2^{nd} ETL in the red R and blue B subpixels, and is provided between the second green emission layer 2^{nd} G-EML and the second N-type charge generation layer 2^{nd} N-CGL in the green G subpixel. In this case, the second hole blocking layer 2^{nd} HBL may be formed of the same material at the same thickness in the red R, green G, and blue B subpixels, but not limited thereto. The second hole blocking layer 2^{nd} HBL may be formed of various materials generally known to those in the art. In the green G subpixel, the second hole blocking layer 2^{nd} HBL may be omitted.

The second electron transporting layer 2^{nd} ETL may be provided between the second hole blocking layer 2^{nd} HBL and the electron injection layer EIL in the red R and blue B subpixels, and may be formed of the same material as the same thickness in the red R and blue B subpixels, but is not limited thereto. The second electron transporting layer 2^{nd} ETL may be formed of various materials generally known to those in the art. Any one of the second hole blocking layer 2^{nd} HBL and the second electron transporting layer 2^{nd} ETL may be omitted.

In the green G subpixel, the second N-type charge generation layer 2^{nd} N-CGL, the second P-type charge generation layer 2^{nd} P-CGL, and the third N-type charge generation layer 3^{rd} N-CGL are sequentially stacked between the second hole blocking layer 2^{nd} HBL and the electron injection layer EIL.

Generally, in order to amplify light through a constructive interference by the micro-cavity, the distance between the first electrode 1^{st} electrode and the second electrode 2^{nd} electrode is designed to be an integer multiple of half wavelength λ / 2 of light emitted from the emission layer R-EML, G-EML, and B-EML, and more specifically, designed to be an integer multiple of λ / 2n in consideration of a refractive index 'n' of an organic layer between the first electrode 1^{st} electrode and the second electrode 2^{nd} electrode.

Therefore, the distance between the first electrode 1^{st} electrode and the second electrode 2^{nd} electrode in the red R subpixel that emits red light having the longest wavelength is the longest, and the distance between the first electrode 1^{st} electrode and the second electrode 2^{nd} electrode in the blue B subpixel that emits blue light having the shortest wavelength is the shortest.

However, according to one embodiment of the present disclosure, as described in FIG. 1, a configuration of increasing the thickness of the green G subpixel may be employed to reduce the capacitance of the green G subpixel. Accordingly, the distance between the first electrode 1^{st} electrode and the second electrode 2^{nd} electrode in the green G subpixel may be longer than the distance between the first electrode 1^{st} electrode and the second electrode 2^{nd} electrode in the red R subpixel. Also, the distance between the first electrode 1^{st} electrode and the second electrode 2^{nd} electrode in the green G subpixel may be longer than the distance between the first electrode 1^{st} electrode and the second electrode 2^{nd} electrode in the blue B subpixel. In addition, the distance between the first electrode 1^{st} electrode and the second electrode 2^{nd} electrode in the red R subpixel may be longer than the distance between the first electrode 1^{st} electrode and the second electrode 2^{nd} electrode in the blue B subpixel.

In order to have the above-described configuration, for example, the distance between the first electrode 1^{st} electrode and the second electrode 2^{nd} electrode in the red R subpixel is set to be twice the λ / 2n, and the distance between the first electrode 1^{st} electrode and the second electrode 2^{nd} electrode in the blue B subpixel is set to be twice the λ / 2n, and the distance between the first electrode 1^{st} electrode and the second electrode 2^{nd} electrode in the green G subpixel may be 3 times the λ / 2n.

In order to provide the longest distance between the first electrode 1^{st} electrode and the second electrode 2^{nd} electrode in the green G subpixel, according to one embodiment of the present disclosure, in the case of the green G pixel, the second N-type charge generation layer 2^{nd} N-CGL, the second P-type charge generation layer 2^{nd} P-CGL, and the third N-type charge generation layer 3^{rd} N-CGL may be sequentially stacked between the second hole blocking layer 2^{nd} HBL and the electron injection layer EIL.

There is another method for providing the longest distance between the first electrode 1^{st} electrode and the second electrode 2^{nd} in the green G pixel. For example, the second electron transporting layer 2^{nd} ETL may be formed between the second hole blocking layer 2^{nd} HBL and the electron injection layer EIL in the green G subpixel, and the second electron transporting layer 2^{nd} ETL of the green G subpixel may be thicker than the second electron transporting layer 2^{nd} ETL in each of the red R and blue B subpixels. However, in this case, the driving voltage is increased in the green G subpixel, thereby significantly reducing efficiency and lifespan of the green G subpixel.

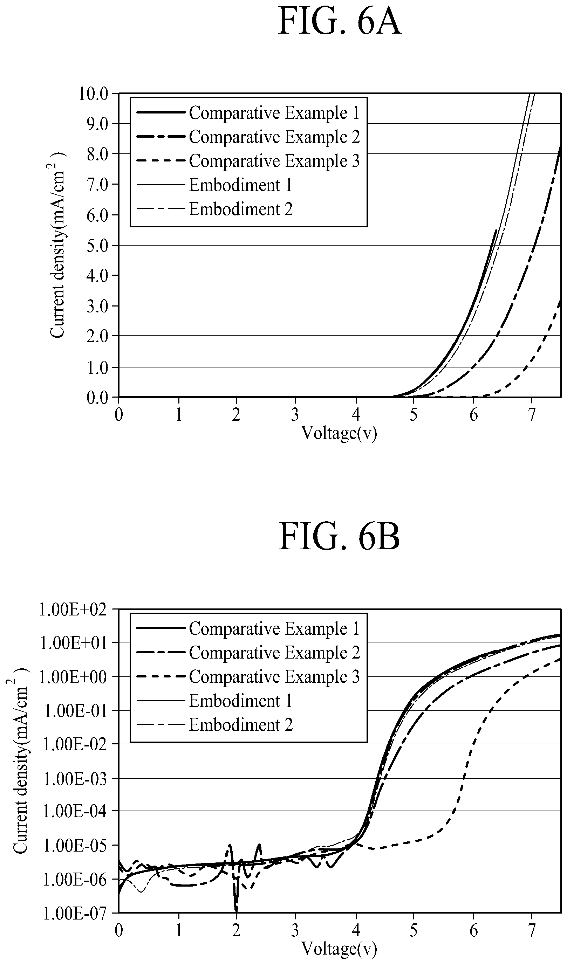

Accordingly, in one embodiment of the present disclosure, there is proposed a method for making the distance between the first electrode 1^{st} electrode and the second electrode 2^{nd} electrode in the green G subpixel be longer than the distance between the first electrode 1^{st} electrode and the second electrode 2^{nd} electrode in each of the red R and blue B subpixels, and also preventing or minimizing the increase of the driving voltage. Specifically, according to one embodiment of the present disclosure, the second N-type charge generation layer 2^{nd} N-CGL, the second P-type charge generation layer 2^{nd} P-CGL, and the third N-type charge generation layer 3^{rd} N-CGL are sequentially stacked between the second hole blocking layer 2^{nd} HBL and the electron injection layer EIL. This stack structure according to the present disclosure facilitates to prevent the driving voltage from being increased and to prevent the lowering of efficiency, which will be easily understood with reference to the following FIGs. 6a and 6b and Table 1.

The second N-type charge generation layer 2^{nd} N-CGL and the third N-type charge generation layer 3^{rd} N-CGL may be made of the same material as or different materials from each other, and each of the second N-type charge generation layers 2^{nd} N-CGL and the third N-type charge generation layer 3^{rd} N-CGL may be made of the same material as or different material from the first N-type charge generation layer 1^{st} N-CGL.

Each of the thickness of the second N-type charge generation layer 2^{nd} N-CGL and the thickness of the third N-type charge generation layer 3^{rd} N-CGL may be larger than the thickness of the first N-type charge generation layer 1^{st} N-CGL. In this case, the thickness of the second N-type charge generation layer 2^{nd} N-CGL and the thickness of the third N-type charge generation layer 3^{rd} N-CGL may be the same as or different from each other.

The second P-type charge generation layer 2^{nd} P-CGL may be made of the same material as the first P-type charge generation layer 1^{st} P-CGL, or may be made of the different material from the first P-type charge generation layer 1^{st} P-CGL. However, the thickness of the second P-type charge generation layer 2^{nd} P-CGL may be larger than the thickness of the first P-type charge generation layer 1^{st} P-CGL.

Meanwhile, when the thickness of the second P-type charge generation layer 2^{nd} P-CGL is larger than the thickness in each of the second N-type charge generation layer 2^{nd} N-CGL and the third N-type charge generation layer 3^{rd} N-CGL, electrons may not be smoothly moved in the electron injection layer EIL to the direction of the second green emission layer G-EML. Accordingly, the thickness of the second P-type charge generation layer 2^{nd} P-CGL may be the same as or smaller than the thickness of each of the second N-type charge generation layer 2^{nd} N-CGL and the third N-type charge generation layer 3^{rd} N-CGL.

The thickness difference occurs between the three-layered structure of the second N-type charge generation layer 2^{nd} N-CGL / the second P-type charge generation layer 2^{nd} P-CGL / the third N-type charge generation layer 3^{rd} N-CGL provided in the green G subpixel and the second electron transporting layer ETL provided in the red R and blue B subpixels. As a result, the distance from the second electrode 2^{nd} electrode of the green G subpixel to the second green emission layer 2^{nd} G-EML may be longer than the distance from the second electrode 2^{nd} electrode of the red R subpixel to the second red emission layer 2^{nd} R-EML. In addition, the distance from the second electrode 2^{nd} electrode of the green G subpixel to the second green emission layer 2^{nd} G-EML may be longer than the distance from the second electrode 2^{nd} electrode of the blue B subpixel to the second blue emission layer 2^{nd} B-EML.

The electron injection layer EIL may be provided between the second electron transporting layer 2^{nd} ETL and the second electrode 2^{nd} electrode in the red R and blue B subpixels, and may be provided between the third N-type charge generation layer 3^{rd} N-CGL and the second electrode 2^{nd} electrode in the green G subpixel. The electron injection layer EIL may be formed of the same material at the same thickness in each of the red R, green G, and blue B subpixels, but is not limited thereto. The electron injection layer EIL may be formed of various materials generally known to those in the art.

Although not shown, a capping layer may be additionally provided on the second electrode 2^{nd} electrode.

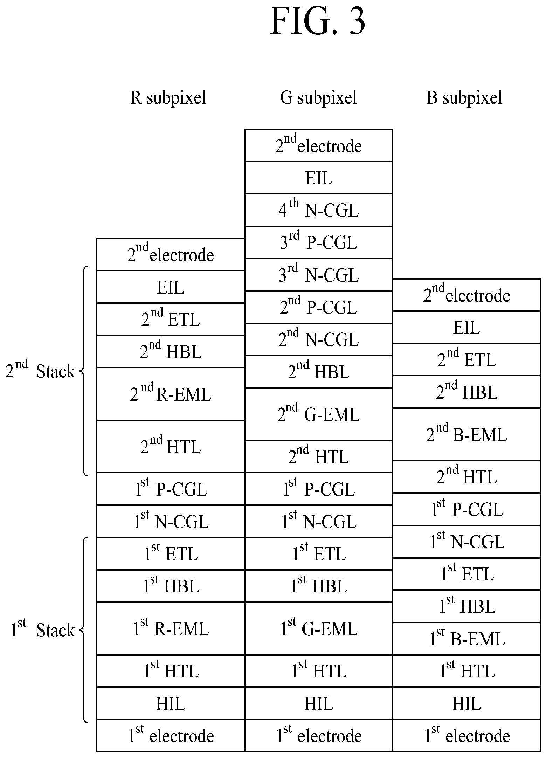

FIG. 3 is a cross sectional view schematically illustrating an electroluminescent display device according to another embodiment of the present disclosure. FIG. 3 is the same as the electroluminescent display device shown in FIG. 2 except that a configuration provided between a second hole blocking layer 2^{nd} HBL and an electron injection layer EIL is changed in a green G subpixel. Therefore, the same reference signs are assigned to the same configuration. Hereinafter, only different configurations will be described in detail.

As shown in FIG. 3, a second N-type charge generation layer 2^{nd} N-CGL, a second P-type charge generation layer 2^{nd} P-CGL, a third N-type charge generation layer 3^{rd} N-CGL, a third P-type charge generation layer 3^{rd} P-CGL, and a fourth N-type charge generation layer 4^{th} N-CGL are sequentially stacked between a second hole blocking layer 2^{nd} HBL and an electron injection layer EIL in a green G subpixel.

The second N-type charge generation layer 2^{nd} N-CGL, the third N-type charge generation layer 3^{rd} N-CGL, and the fourth N-type charge generation layer 4^{th} N-CGL may be made of the same material as or different materials from each other, and each of the second N-type charge generation layer 2^{nd} N-CGL, the third N-type charge generation layer 3^{rd} N-CGL, and the fourth N-type charge generation layer 4^{th} N-CGL may be made of the same material as or different material from the first N-type charge generation layer 1^{st} N-CGL.

However, each of the thickness of the second N-type charge generation layer 2^{nd} N-CGL, the thickness of the third N-type charge generation layer 3^{rd} N-CGL, and the thickness of the fourth N-type charge generation layer 4^{th} N-CGL may be larger than the thickness of the first N-type charge generation layer 1^{st} N-CGL. In this case, the thickness of the second N-type charge generation layer 2^{nd} N-CGL, the thickness of the third N-type charge generation layer 3^{rd} N-CGL, and the thickness of the fourth N-type charge generation layer 4^{th} N-CGL may be the same as or different from each other.

The second P-type charge generation layer 2^{nd} P-CGL and the third P-type charge generation layer 3^{rd} P-CGL may be made of the same material as or different materials from each other, and each of the second P-type charge generation layer 2^{nd} P-CGL and the third P-type charge generation layer 3^{rd} P-CGL may be made of the same material as the first P-type charge generation layer 1^{st} P-CGL, or may be made of the different material from the first P-type charge generation layer 1^{st} P-CGL.

However, each of the thickness of the second P-type charge generation layer 2^{nd} P-CGL and the thickness of the third P-type charge generation layer 3^{rd} P-CGL may be larger than the thickness of the first P-type charge generation layer 1^{st} P-CGL. The thickness of the second P-type charge generation layer 2^{nd} P-CGL and the thickness of the third P-type charge generation layer 3^{rd} P-CGL may be the same as or different from each other.

When the thickness of the second P-type charge generation layer 2^{nd} P-CGL is larger than each of the thickness of the second N-type charge generation layer 2^{nd} N-CGL, the thickness of the third N-type charge generation layer 3^{rd} N-CGL, and the thickness of the fourth N-type charge generation layer 4^{th} N-CGL, electrons may not be smoothly moved in the electron injection layer EIL to the direction of the second green emission layer 2^{nd} G-EML. Thus, the thickness of the second P-type charge generation layer 2^{nd} P-CGL may be the same as or smaller than each of the thickness of the second N-type charge generation layer 2^{nd} N-CGL, the thickness of the third N-type charge generation layer 3^{rd} N-CGL, and the thickness of the fourth N-type charge generation layer 4^{th} N-CGL.

In addition, even when the thickness of the third P-type charge generation layer 3^{rd} P-CGL is larger than each of the thickness of the second N-type charge generation layer 2^{nd} N-CGL, the thickness of the third N-type charge generation layer 3^{rd} N-CGL, and the thickness of the fourth N-type charge generation layer 4^{th} N-CGL, electrons may not be smoothly moved in the electron injection layer EIL to the direction of the second green emission layer 2^{nd} G-EML.

Accordingly, the thickness of the third P-type charge generation layer 3^{rd} P-CGL may be the same as or smaller than each of the thickness of the second N-type charge generation layer 2^{nd} N-CGL, the thickness of the third N-type charge generation layer 3^{rd} N-CGL, and the thickness of the fourth N-type charge generation layer 4^{th} N-CGL.

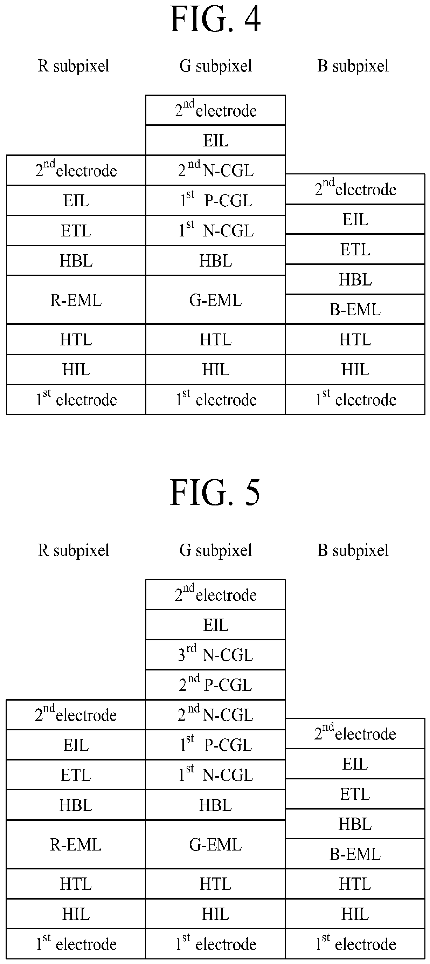

FIG. 4 is a cross sectional view schematically illustrating an electroluminescent display device according to another embodiment of the present disclosure. The above-mentioned electroluminescent display device shown in FIGs. 2 and 3 relates to a 2-stack structure, whereas electroluminescent display devices of FIG. 4 and FIG. 5 relate to a 1-stack structure.

As shown in FIG. 4, the electroluminescent display device according to another embodiment of the present disclosure includes a red R subpixel, a green G subpixel, and a blue B subpixel.

The red R subpixel may include a hole injection layer HIL, a hole transporting layer HTL, a red emission layer R-EML, a hole blocking layer HBL, an electron transporting layer ETL, and an electron injection layer EIL, which are sequentially stacked between a first electrode 1^{st} electrode and a second electrode 2^{nd} electrode.

The green G subpixel may include a hole injection layer HIL, a hole transporting layer HTL, a green emission layer G-EML, a hole blocking layer HBL, a first N-type charge generation layer 1^{st} N-CGL, a first P-type charge generation layer 1^{st} P-CGL, a second N-type charge generation layer 2^{nd} N-CGL, and an electron injection layer EIL, which are sequentially stacked between the first electrode 1^{st} electrode and the second electrode 2^{nd} electrode.

The blue B subpixel may include a hole injection layer HIL, a hole transporting layer HTL, a blue emission layer B-EML, a hole blocking layer HBL, an electron transporting layer ETL, and an electron injection layer EIL, which are sequentially stacked between the first electrode 1^{st} electrode and the second electrode 2^{nd} electrode.

The first electrode 1^{st} electrode and the second electrode 2^{nd} electrode are the same as those of the afore-mentioned embodiment.

The hole injection layer HIL may be provided between the first electrode 1^{st} electrode and the hole transporting layer HTL. The hole injection layer HIL may be formed of the same material at the same thickness in each of the red R, green G, and blue B subpixels, but not limited thereto.

The hole transporting layer HTL may be provided between the hole injection layer HIL and the red / green / blue emission layers R-EML / G-EML / B-EML. The hole transporting layer HTL may be formed of the same material at the same thickness in each of the red R, green G, and blue B subpixels, but is not limited thereto. For example, in order to realize the micro-cavity characteristic, the thickness of the hole transporting layer HTL of the red R subpixel may be larger than the thickness of the hole transporting layer HTL of the green G subpixel, and the thickness of the hole transporting layer HTL of the green G subpixel may be larger than the thickness of the hole transporting layer HTL of the blue B subpixel.

Each of the red / green / blue emission layers R-EML / G-EML / B-EML is provided between the hole transporting layer HTL and the hole blocking layer HBL. In order to realize the micro-cavity characteristic, the thickness of the blue emission layer B-EML may be smaller than the thickness of each of the red emission layer R-EML and the green emission layer G-EML, but is not limited thereto.

The hole blocking layer HBL is provided between the red / blue emission layers R-EML / B- EML and the electron transporting layer ETL in the red R and blue B subpixels, and is provided between the green emission layer G-EML and the first N-type charge generation layer 1^{st} N-CGL in the green G subpixel. The hole blocking layer HBL may be formed of the same material at the same thickness in each of the red R, green G, and blue B subpixels, but are not limited thereto. In the green G subpixel, the hole blocking layer HBL may be omitted.

The electron transporting layer ETL may be provided between the hole blocking layer HBL and the electron injection layer EIL in the red R and blue B subpixels. The electron transporting layer ETL may be formed of the same material at the same thickness in the red R and blue B subpixels, but is not limited thereto.

Any one of the hole blocking layer HBL and the electron transporting layer ETL may be omitted.

In the green G subpixel, the first N-type charge generation layer 1^{st} N-CGL, the first P-type charge generation layer 1^{st} P-CGL, and the second N-type charge generation layer 2^{nd} N-CGL are sequentially stacked between the hole blocking layer HBL and the electron injection layer EIL.

According to another embodiment of the present disclosure, the distance between the first electrode 1^{st} electrode and the second electrode 2^{nd} electrode in the green G subpixel is longer than the distance between the first electrode 1^{st} electrode and the second electrode 2^{nd} electrode in the red R subpixel, and the distance between the first electrode 1^{st} electrode and the second electrode 2^{nd} electrode in the green G subpixel is longer than the distance between the first electrode 1^{st} electrode and the second electrode 2^{nd} electrode in the blue B sub pixel. In addition, the distance between the first electrode 1^{st} electrode and the second electrode 2^{nd} electrode in the red R subpixel is longer than the distance between the first electrode 1^{st} electrode and the second electrode 2^{nd} electrode in the blue B subpixel.

In order to have the above-described configuration, for example, the distance between the first electrode 1^{st} electrode and the second electrode 2^{nd} electrode in the red R subpixel is set to be 1 time of λ / 2n, and the distance between the first electrode 1^{st} electrode and the second electrode 2^{nd} electrode in the blue B subpixel is set to be 1 time of λ / 2n, and the distance between the first electrode 1^{st} electrode and the second electrode 2^{nd} electrode in the green G subpixel may be set to be twice the λ / 2n.

The first N-type charge generation layer 1^{st} N-CGL and the second N-type charge generation layer 2^{nd} N-CGL may be made of the same material as or different materials from each other.

The thickness of the first N-type charge generation layer 1^{st} N-CGL and the thickness of the second N-type charge generation layer 2^{nd} N-CGL may be the same as or different from each other. In addition, the thickness of the first P-type charge generation layer 1^{st} P-CGL may be the same as or smaller than each of the thickness of the first N-type charge generation layer 1^{st} N-CGL and the thickness of the second N-type charge generation layer 2^{nd} N-CGL.

Due to the thickness difference between the electron transporting layer ETL and the three-layered structure of the first N-type charge generation layer 1^{st} N-CGL / the first P-type charge generation layer 1^{st} P-CGL / the second N-type charge generation layer 2^{nd} N-CGL in the red R, green G, and blue B subpixels, the distance from the second electrode 2^{nd} electrode of the green G subpixel to the green emission layer G-EML may be longer than each of the distance from the second electrode 2^{nd} electrode of the red R subpixel to the red emission layer R-EML and the distance from the second electrode 2^{nd} electrode of the blue B subpixel to the blue emission layer B-EML.

The electron injection layer EIL may be provided between the electron transporting layer ETL and the second electrode 2^{nd} electrode in the red R and blue B subpixels, and may be provided between the second N-type charge generation layer 2^{nd} N-CGL and the second electrode 2^{nd} electrode in the green G subpixel. The electron injection layer EIL may be formed of the same material at the same thickness in the red R, green G, and blue B subpixels, but is not limited thereto.

FIG. 5 is a cross sectional view schematically illustrating an electroluminescent display device according to another embodiment of the present disclosure. FIG. 5 is the same as the electroluminescent display device shown in FIG. 4 except that a configuration provided between a hole blocking layer HBL and an electron injection layer EIL is changed in a green G subpixel. Therefore, the same reference signs are assigned to the same configuration. Hereinafter, only different configurations will be described in detail.

As shown in FIG. 5, a first N-type charge generation layer 1^{st} N-CGL, a first P-type charge generation layer 1^{st} P-CGL, a second N-type charge generation layer 2^{nd} N-CGL, a second P-type charge generation layer 2^{nd} P-CGL, and a third N-type charge generation layer 3^{rd} N-CGL are sequentially stacked between a hole blocking layer HBL and an electron injection layer EIL in a green G subpixel.

The first N-type charge generation layer 1^{st} N-CGL, the second N-type charge generation layer 2^{nd} N-CGL, and the third N-type charge generation layer 3^{rd} N-CGL may be made of the same material as or different materials from each other. In addition, the thickness of the first N-type charge generation layer 1^{st} N-CGL, the thickness of the second N-type charge generation layer 2^{nd} N-CGL, and the thickness of the third N-type charge generation layer 3^{rd} N-CGL may be the same as or different from each other.

The first P-type charge generation layer 1^{st} P-CGL and the second P-type charge generation layer 2^{nd} P-CGL may be made of the same material as or different materials from each other. In addition, the thickness of the first P-type charge generation layer 1^{st} P-CGL and the thickness of the second P-type charge generation layer 2^{nd} P-CGL may be the same as or different from each other.

Also, each of the thickness of the first P-type charge generation layer 1^{st} P-CGL and the thickness of the second P-type charge generation layer 2^{nd} P-CGL may be the same as or smaller than each of the thickness of the first N-type charge generation layer 1^{st} N-CGL, the thickness of the second N-type charge generation layer 2^{nd} N-CGL, and the thickness of the third N-type charge generation layer 3^{rd} N-CGL.

In the embodiment of FIGs. 2 and 4, the three-layered structure of the N-type charge generation layer N-CGL, the P-type charge generation layer P-CGL, and the N-type charge generation layer N-CGL sequentially stacked is provided between the green emission layer G-EML and the electron injection layer EIL in the green G subpixel.

In the embodiment of FIGs. 3 and 5, the five-layered structure of the N-type charge generation layer N-CGL, the P-type charge generation layer P-CGL, the N-type charge generation layer N-CGL, the P-type charge generation layer P-CGL, and the N-type charge generation layer N-CGL sequentially stacked is provided between the green emission layer G-EML and the electron injection layer EIL in the green G subpixel.

The present disclosure is not limited to the above embodiments. If needed, it is possible to form a seven-layered structure of the N-type charge generation layer N-CGL, the P-type charge generation layer P-CGL, the N-type charge generation layer N-CGL, the P-type charge generation layer P-CGL, the N-type charge generation layer N-CGL, the P-type charge generation layer P-CGL, and the N-type charge generation layer N-CGL sequentially stacked between the green emission layer G-EML and the electron injection layer EIL, a nine-layered structure, or an eleven-layered structure. That is, the present disclosure may include any odd-numbered stack structure in which the N-type charge generation layer N-CGL and the P-type charge generation layer P-CGL are alternately repeated and stacked between the green emission layer G-EML and the electron injection layer EIL in the green G subpixel, and each of the bottom layer and the top layer thereof is formed of the N-type charge generation layer.

In the embodiment shown in FIGs. 2 to 5, the distance between the first electrode 1^{st} electrode and the second electrode 2^{nd} electrode in the green G subpixel is longer than the distance between the first electrode 1^{st} electrode and the second electrode 2^{nd} electrode in each of the red R and the blue B subpixels, but the present disclosure is not limited thereto.

That is, as shown in FIG. 1, when the capacitance of the red R subpixel is reduced and the capacitance of the blue B subpixel is reduced, the change in the temperature luminance sensitivity TLS may be reduced.

Thus, although not shown, it is possible to form a three-layered structure of sequentially stacking an N-type charge generation layer N-CGL, a P-type charge generation layer P-CGL, and an N-type charge generation layer N-CGL between the red emission layer R-EML and the electron injection layer EIL in the red R subpixel, or a five-layered structure of sequentially stacking an N-type charge generation layer N-CGL, a P-type charge generation layer P-CGL, an N-type charge generation layer N-CGL, a P-type charge generation layer P-CGL, and an N-type charge generation layer N-CGL between the red emission layer R-EML and the electron injection layer EIL in the red R subpixel. In this case, the distance between the first electrode 1^{st} electrode and the second electrode 2^{nd} electrode in the red R subpixel is longer than the distance between the first electrode 1^{st} electrode and the second electrode 2^{nd} electrode in the green G subpixel, and is longer than the distance between the first electrode 1^{st} electrode and the second electrode 2^{nd} electrode in the blue B subpixel.

Also, it is possible to form a three-layered structure of sequentially stacking an N-type charge generation layer N-CGL, a P-type charge generation layer P-CGL, and an N-type charge generation layer N-CGL between the blue emission layer B-EML and the electron injection layer EIL in the blue B subpixel, or a five-layered structure of sequentially stacking an N-type charge generation layer N-CGL, a P-type charge generation layer P-CGL, an N-type charge generation layer N-CGL, a P-type charge generation layer P-CGL, and an N-type charge generation layer N-CGL between the blue emission layer B-EML and the electron injection layer EIL in the blue B subpixel. In this case, the distance between the first electrode 1^{st} electrode and the second electrode 2^{nd} electrode in the blue B subpixel is longer than the distance between the first electrode 1^{st} electrode and the second electrode 2^{nd} electrode in the green G subpixel, and is longer than the distance between the first electrode 1^{st} electrode and the second electrode 2^{nd} electrode in the red R subpixel.

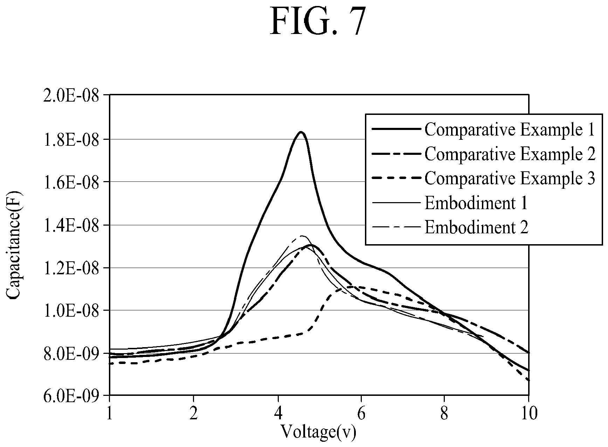

FIGs. 6a (linear scale) and 6b (logarithmic scale) both show the same current density-voltage curve of Comparative examples 1 to 3 and Embodiments 1 and 2, and FIG. 7 shows capacitance-voltage curves of Comparative Examples 1 to 3 and Embodiments 1 and 2. Table 1 below shows the driving voltage, efficiency, lifespan, and capacitance-voltage specification of Comparative Examples 1 to 3 and Embodiments 1 and 2.

**[Table 1]**

| | Driving voltage | Efficiency | Lifespan | CV |
|---|---|---|---|---|
| Comparative Example 1 | 0.0 | 100% | 100% | 100% |
| Comparative Example 2 | +0.8 | 60% | 40% | 72% |
| Comparative Example 3 | +1.6 | 40% | 50% | 62% |
| Embodiment 1 | 0.0 | 97% | 95% | 71% |
| Embodiment 2 | +0.1 | 95% | 95% | 74% |

In FIGs. 6a and 6b and 7, and Table 1, Comparative Examples 1 to 3 and Embodiments 1 and 2 correspond to the stacked structure of the following green subpixel. In the following stacked structure, 'Å' corresponds to the thickness in each layer, and '%' corresponds to the dopant concentration included in each layer.

The Comparative Example 1 is a structure having a first stack, a second stack, a charge generation layer provided between the first stack and the second stack, and a second electrode (Ag:Mg = 9:1, 155Å) and a capping layer (630Å) which are sequentially stacked on the second stack. The first stack of the Comparative Example 1 is composed of a hole injection layer HIL (100Å, 4% P-HTL), a first hole transporting layer 1^{st} HTL (300Å), a first green emission layer 1^{st} G-EML (380Å, 8%), and a first hole blocking layer 1^{st} HBL (80Å) The charge generation layer of the Comparative Example 1 is comprised of a first N-type charge generation layer 1^{st} N-CGL (120Å, 2%) and a first P-type charge generation layer 1^{st} P-CGL (75Å, 12%). The second stack of the Comparative Example 1 is comprised of a second hole transporting layer 2^{nd} HTL (300Å), a second green emission layer 2^{nd} G-EML (380Å, 8%), a second hole blocking layer 2^{nd} HBL (50Å), a second electron transporting layer 2^{nd} ETL (300Å), and an electron injection layer EIL (Yb:LiF = 1:1, 20Å)

The Comparative Example 2 is a stack structure in which the thickness of the second electron transporting layer 2^{nd} ETL is increased in the Comparative Example 1. More specifically, the second electron transporting layer 2^{nd} ETL (1000Å) is applied instead of the second electron transporting layer 2^{nd} ETL (300Å)

The Comparative Example 3 is a stacked structure in which a second N-type charge generation layer 2^{nd} N-CGL (500Å, 2%) and a second P-type charge generation layer 2^{nd} P-CGL (500Å, 12%), which are sequentially stacked, are applied instead of the second electron transporting layer 2^{nd} ETL (300Å) in the Comparative Example 1.

The Embodiment 1 is a three-layered stacked structure in which a second N-type charge generation layer 2^{nd} N-CGL (333Å, 2%), a second P-type charge generation layer 2^{nd} P-CGL (333Å, 12%), and a third N-type charge generation layer 3^{rd} N-CGL (333Å, 2%) are sequentially stacked instead of the second electron transporting layer 2^{nd} ETL (300Å) in the Comparative Example 1.

The Embodiment 2 is a stacked structure in which a second N-type charge generation layer 2^{nd} N-CGL (200Å, 2%), a second P-type charge generation layer 2^{nd} P-CGL (200Å, 12%), a third N-type charge generation layer 3^{rd} N-CGL (200Å, 2%), a third P-type charge generation layer 3^{rd} P-CGL (200Å, 12%), and a fourth N-type charge generation layer 4^{th} N-CGL (200Å, 2%) are applied in sequence instead of the second electron transporting layer 2^{nd} ETL (300Å) in the Comparative Example 1.

As shown in FIGs. 6a and 6b and 7 and Table 1, the Comparative Example 1 is a reference structure.

Referring to FIG. 7 and Table 1, the capacitance-voltage CV in the Comparative Example 2, the Comparative Example 3, and the Embodiments 1 and 2 may be reduced as compared to the Comparative Example 1, whereby the variation of the luminance according to the temperature change may be reduced.

However, referring to FIGs. 6a and 6b and Table 1, in the case of the Comparative Example 2, the carrier mobility is reduced by simply changing only the thickness of the second electron transporting layer ETL, as compared to the Comparative Example 1. Thus, in the case of the Comparative Example 2, the driving voltage is largely increased as compared to the Comparative example 1, whereby the efficiency and lifespan thereof are greatly reduced.

In the case of the Comparative Example 3, the second electron transporting layer ETL of the Comparative Example 1 is changed into the two-layered structure of the second N-type charge generation layer 2^{nd} N-CGL and the second P-type charge generation layer 2^{nd} P-CGL to generate the electron blocking by the second P-type charge generation layer 2^{nd} P-CGL, thereby increasing the driving voltage and reducing the efficiency and lifespan, as compared to the Comparative Example 2.

In contrast, in the case of the Embodiment 1, the mobility of the carrier is increased owing to the charge generation effect by the three-layered structure of the second N-type charge generation layer 2^{nd} N-CGL, the second P-type charge generation layer 2^{nd} P-CGL, and the third N-type charge generation layer 3^{rd} N-CGL. Thus, even though the thickness of the Embodiment 1 is increased as compared to that of the Comparative Example 1, the driving voltage of the Embodiment 1 is not increased as compared to that of the Comparative Example 1, and the efficiency and lifetime thereof are similar to those of the Comparative Example 1.

In the case of the Embodiment 2, the mobility of the carrier is increased owing to the charge generation effect by the five-layered structure of the second N-type charge generation layer 2^{nd} N-CGL, the second P-type charge generation layer 2^{nd} P-CGL, the third N-type charge generation layer 3^{rd} N-CGL, the third P-type charge generation layer 3^{rd} P-CGL, and the fourth N-type charge generation layer 4^{th} N-CGL. Thus, even though the thickness of the Embodiment 2 is increased as compared to that of the Comparative Example 1, the driving voltage of the Embodiment 2 is not increased as compared to that of the Comparative Example 1, and the efficiency and lifetime thereof are similar to those of the Comparative Example 1.

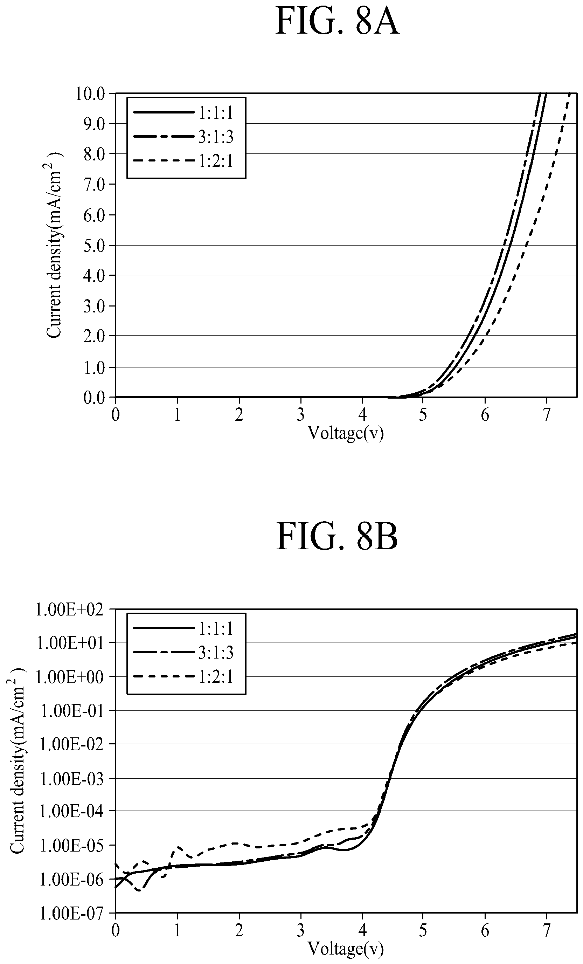

FIGs. 8a (linear scale) and 8b (logarithmic scale) both show the same current density-voltage curve according to the thickness change in the second N-type charge generation layer 2^{nd} N-CGL, the second P-type charge generation layer 2^{nd} P-CGL, and the third N-type charge generation layer 3^{rd} N-CGL in the Embodiment 1.

The Embodiment 1 of FIG. 8a and 8b is the same structure as those of the above Embodiment 1 of FIGs. 6a and 6b and 7 and Table 1.

As shown in FIGs. 8a and 8b, as compared to the case when the thickness in each of the second N-type charge generation layer 2^{nd} N-CGL, the second P-type charge generation layer 2^{nd} P-CGL, and the third N-type charge generation layer 3^{rd} N-CGL is 1:1:1, the case when the thickness in each of the second N-type charge generation layer 2^{nd} N-CGL, the second P-type charge generation layer 2^{nd} P-CGL, and the third N-type charge generation layer 3^{rd} N-CGL is 1:2:1 results in the increase of the driving voltage.

In addition, as compared to the case when the thickness in each of the second N-type charge generation layer 2^{nd} N-CGL, the second P-type charge generation layer 2^{nd} P-CGL, and the third N-type charge generation layer 3^{rd} N-CGL is 1:1:1, the case when the thickness in each of the second N-type charge generation layer 2^{nd} N-CGL, the second P-type charge generation layer 2^{nd} P-CGL, and the third N-type charge generation layer 3^{rd} N-CGL is 3:1:3 results in the decrease of the driving voltage.

Therefore, when the thickness of the second P-type charge generation layer 2^{nd} P-CGL is greater than each of the thickness of the second N-type charge generation layer 2^{nd} N-CGL and the thickness of the third N-type charge generation layer 3^{rd} N-CGL, the driving voltage may be increased.

Accordingly, the present disclosure has the following advantages.

According to one embodiment of the present disclosure, since the second N-type charge generation layer, the second P-type charge generation layer, and the third N-type charge generation layer are sequentially stacked between the emission layer and the second electrode, the thickness of the green subpixel is increased and the capacitance is reduced, thereby reducing the change in the temperature luminance sensitivity TLS of the electroluminescent display device.

In addition, according to one embodiment of the present disclosure, the second N-type charge generation layer, the second P-type charge generation layer, and the third N-type charge generation layer are sequentially stacked between the emission layer and the second electrode. Accordingly, even though the thickness of the green subpixel is increased, it is possible to prevent the deterioration of efficiency and the reduction of lifespan in the electroluminescent display device without the increase of the driving voltage.

Also disclosed are the following numbered clauses:
1. An electroluminescent display device comprising: a first electrode and a second electrode; a first stack including a first emission layer between the first electrode and the second electrode; a second stack including a second emission layer between the first stack and the second electrode; and a charge generation layer including a first N-type charge generation layer and a first P-type charge generation layer between the first stack and the second stack, wherein the second stack includes a second N-type charge generation layer, a second P-type charge generation layer, and a third N-type charge generation layer sequentially stacked between the second emission layer and the second electrode.
2. The electroluminescent display device according to clause 1, wherein the first emission layer and the second emission layer are formed of green emission layers.
3. The electroluminescent display device according to clause 1 or 2, wherein each of the thickness of the second N-type charge generation layer and the thickness of the third N-type charge generation layer is larger than the thickness of the first N-type charge generation layer.
4. The electroluminescent display device according to any preceding clause, wherein the thickness of the second P-type charge generation layer is larger than the thickness of the first P-type charge generation layer.
5. The electroluminescent display device according to any preceding clause, wherein the thickness of the second P-type charge generation layer is the same as or smaller than the thickness of the second N-type charge generation layer.
6. The electroluminescent display device according to any preceding clause, wherein the second stack further includes an electron injection layer between the third N-type charge generation layer and the second electrode.
7. The electroluminescent display device according to any preceding clause, wherein the second stack further includes a third P-type charge generation layer and a fourth N-type charge generation layer sequentially stacked on the third N-type charge generation layer.
8. An electroluminescent display device comprising: a first electrode and a second electrode; an emission layer between the first electrode and the second electrode; and a first N-type charge generation layer, a first P-type charge generation layer and a second N-type charge generation layer sequentially stacked between the emission layer and the second electrode.
9. The electroluminescent display device according to clause 8, wherein the emission layer is formed of a green emission layer.
10. The electroluminescent display device according to clause 8 or 9, wherein the thickness of the first P-type charge generation layer is the same as or smaller than the thickness of the first N-type charge generation layer.
11. The electroluminescent display device according to any of clauses 8 to 10, further comprising an electron injection layer between the second N-type charge generation layer and the second electrode.
12. The electroluminescent display device according to any of clauses 8 to 11, further comprising a second P-type charge generation layer and a third N-type charge generation layer sequentially stacked on the second N-type charge generation layer.
13. An electroluminescent display device comprising: a red subpixel for emitting red light; a green subpixel for emitting green light; and a blue subpixel for emitting blue light, wherein each of the red, green, and blue subpixels includes a first electrode, a second electrode, and at least one emission layer between the first electrode and the second electrode, and a distance between the first electrode and the second electrode in the green subpixel is longer than each of a distance between the first electrode and the second electrode in the red subpixel and a distance between the first electrode and the second electrode in the blue subpixel.
14. The electroluminescent display device according to clause 13, wherein each of the red and green subpixels includes: a first stack including a first emission layer between the first electrode and the second electrode; a second stack including a second emission layer between the first stack and the second electrode; and a charge generation layer including a first N-type charge generation layer and a first P-type charge generation layer between the first stack and the second stack, wherein the second stack of the red subpixel includes an electron transporting layer between the second emission layer and the second electrode, and wherein the second stack of the green subpixel includes a second N-type charge generation layer, a second P-type charge generation layer, and a third N-type charge generation layer sequentially stacked between the second emission layer and the second electrode.
15. The electroluminescent display device according to clause 14, wherein a distance from the first electrode of the red subpixel to the second emission layer is longer than a distance from the first electrode of the green subpixel to the second emission layer.
16. The electroluminescent display device according to clause 14 or 15, wherein a distance from the second electrode of the green subpixel to the second emission layer is longer than a distance from the second electrode of the red subpixel to the second emission layer.
17. The electroluminescent display device according to any of clauses 14 to 16, wherein the distance between the first electrode of the red subpixel and the second electrode is set to be twice the λ / 2n, and the distance between the first electrode of the green subpixel and the second electrode is set to be 3 times the λ / 2n, wherein 'λ' is a wavelength of emitted light, and 'n' is a refractive index of an organic layer between the first electrode and the second electrode.
18. The electroluminescent display device according to any of clauses 13 to 17, wherein the red subpixel includes an emission layer between the first electrode and the second electrode, and an electron transporting layer between the emission layer and the second electrode, and the green subpixel includes an emission layer between the first electrode and the second electrode, and a first N-type charge generation layer, a first P-type charge generation layer, and a second N-type charge generation layer sequentially stacked between the emission layer and the second electrode.
19. The electroluminescent display device according to clause 18, wherein a distance from the second electrode of the green subpixel to the emission layer is longer than a distance from the second electrode of the red subpixel to the emission layer.
20. The electroluminescent display device according to clause 18 or 19, wherein a distance between the first electrode of the red subpixel and the second electrode is set to be one time of λ / 2n, and a distance between the first electrode of the green subpixel and the second electrode is set to be twice the λ / 2n, where 'λ' is a wavelength of emitted light, and 'n' is a refractive index of an organic layer between the first electrode and the second electrode.

It will be apparent to those skilled in the art that the present disclosure described above is not limited by the above-described embodiments and the accompanying drawings and that various substitutions, modifications, and variations can be made in the present disclosure without departing from the scope of the disclosures.

## Claims

1. An electroluminescent display device comprising:
a first electrode (1^{st} electrode) and a second electrode (2^{nd} electrode);
a first emission layer (1^{st} G-EML) between the first electrode (1^{st} electrode) and the second electrode (2^{nd} electrode);
and
a charge generation layer including a first N-type charge generation layer (1^{st} N-CGL) and a first P-type charge generation layer (1^{st} P-CGL) above the first emission layer (1^{st} G-EML); and
a second N-type charge generation layer (2^{nd} N-CGL)between the first P-type charge generation layer (1^{st} P-CGL) and the second electrode.

2. The electroluminescent display device according to claim 1, the electroluminescent display device further comprising:
a first stack (1^{st} Stack) including the first emission layer (1^{st} G-EML);
a second stack (2^{nd} Stack) including a second emission layer (2^{nd} G-EML) between the first stack (1^{st} Stack) and the second electrode (2^{nd} electrode),
wherein the charge generation layer is between the first stack (1^{st} Stack) and the second stack (2^{nd} Stack),
and
wherein the second stack includes the second N-type charge generation layer (2^{nd} N-CGL), a second P-type charge generation layer (2^{nd} P-CGL), and a third N-type charge generation layer (3^{rd} N-CGL) sequentially stacked between the second emission layer (2^{nd} G-EML) and the second electrode (2^{nd} electrode).

3. The electroluminescent display device according to claim 2, wherein each of the thickness of the second N-type charge generation layer (2^{nd} N-CGL) and the thickness of the third N-type charge generation layer (3^{rd} N-CGL) is larger than the thickness of the first N-type charge generation layer (1^{st} N-CGL).

4. The electroluminescent display device according to claim2 or 3, wherein the thickness of the second P-type charge generation layer (2^{nd} P-CGL) is larger than the thickness of the first P-type charge generation layer (1^{st} P-CGL).

5. The electroluminescent display device according to any of claims 2 to 4, wherein the thickness of the second P-type charge generation layer (2^{nd} P-CGL) is the same as or smaller than the thickness of the second N-type charge generation layer (2^{nd} N-CGL).

6. The electroluminescent display device according to any of claims 2 to 5, wherein the second stack further includes a third P-type charge generation layer (3^{rd} P-CGL) and a fourth N-type charge generation layer (4^{th} N-CGL) sequentially stacked on the third N-type charge generation layer (3^{rd} N-CGL).

7. The electroluminescent display device according to claim1, further comprising a second P-type charge generation layer and a third N-type charge generation layer sequentially stacked on the second N-type charge generation layer.

8. The electroluminescent display device according to any preceding claim, the electroluminescent display device further comprising:
a red (R) subpixel for emitting red light;
a green (G) subpixel for emitting green light; and
a blue (B) subpixel for emitting blue light,
wherein the red (R) subpixel includes a red subpixel first electrode (1^{st} electrode) the second electrode (2^{nd} electrode), and at least one red subpixel emission layer (1^{st} R-EML) between red subpixel first electrode (1^{st} electrode) and the second electrode (2^{nd} electrode),
the blue (B) subpixel includes a blue subpixel first electrode (1^{st} electrode), the second electrode (2^{nd} electrode), and at least one blue subpixel emission layer (1^{st} B-EML) between the blue subpixel first electrode (1^{st} electrode) and the second electrode (2^{nd} electrode),
the green (G) subpixel comprises the first electrode (1^{st} electrode), the second electrode (2^{nd} electrode), the first emission layer (1^{st} G-EML), the charge generation layer and the second N-type charge generation layer (2^{nd} N-CGL), and
a distance between the first electrode (1^{st} electrode) and the second electrode (2^{nd} electrode) in the green (G) subpixel is longer than each of a distance between the red subpixel first electrode (1^{st} electrode) and the second electrode (2^{nd} electrode) in the red subpixel and a distance between the blue subpixel first electrode (1^{st} electrode) and the second electrode (2^{nd} electrode) in the blue subpixel.

9. The electroluminescent display device according to claim 8,
wherein the red (R) subpixel includes:
a red subpixel first stack (1^{st} Stack) including the at least one red subpixel first emission layer (1^{st} R-EML) between the red subpixel first electrode (1^{st} electrode) and the second electrode (2^{nd} electrode);
a red subpixel second stack (2^{nd} Stack) including a red subpixel second emission layer (2^{nd} R-EML, 2^{nd} G-EML) between the red subpixel first stack (1^{st} Stack) and the second electrode (2^{nd} electrode); and
a red subpixel charge generation layer including a red subpixel first N-type charge generation layer (1^{st} N-CGL) and a red subpixel first P-type charge generation layer (1^{st} P-CGL) between the red subpixel first stack (1^{st} Stack) and the red subpixel second stack (2^{nd} Stack),
wherein the red subpixel second stack (2^{nd} Stack) includes an electron transporting layer (2^{nd} ETL) between the red subpixel second emission layer (2^{nd} R-EML) and the second electrode (2^{nd} electrode)).

10. The electroluminescent display device according to claim 9 when dependent on claim 2, wherein a distance from the red subpixel first electrode (1^{st} electrode) of the red (R) subpixel to the red subpixel second emission layer (2^{nd} R-EML) of the red (R) subpixel is longer than a distance from the first electrode (1^{st} electrode) of the green (G) subpixel to the second emission layer (2^{nd} G-EML) in the green (G) subpixel.

11. The electroluminescent display device according to claim 9 or 10 when dependent on claim 2, wherein a distance from the second electrode (2^{nd} electrode) to the second emission layer in the green (G) subpixel (2^{nd} G-EML) is longer than a distance from the second electrode (2^{nd} electrode) to the red subpixel second emission layer in the red (R) subpixel (2^{nd} R-EML).

12. The electroluminescent display device according to any of claims 9 to 11,
wherein the distance between the red subpixel first electrode (1^{st} electrode) and the second electrode (2^{nd} electrode) in the red subpixel is set to be twice λ / 2n, and
the distance between the first electrode (1^{st} electrode) of the green (G) subpixel and the second electrode (2^{nd} electrode) in the green (G) subpixel is set to be 3 times λ / 2n,
wherein λ is a wavelength of light emitted by the respective subpixel, and n is a refractive index of an organic layer between the first electrode (1^{st} electrode) of the respective subpixel and the second electrode (2^{nd} electrode) in the respective subpixel.

13. The electroluminescent display device according to any of claims 8 to 12,
wherein the red (R) subpixel includes a red subpixel electron transporting layer between the red subpixel emission layer (1^{st} R-EML) and the second electrode (2^{nd} electrode).

14. The electroluminescent display device according to claim 13, wherein a distance from the second electrode (2^{nd} electrode) in the green (G) subpixel to the emission layer (1^{st} G-EML) of the green (G) subpixel is longer than a distance from the second electrode (2^{nd} electrode) in the red (R) subpixel to the red subpixel emission layer (1^{st} R-EML).

15. The electroluminescent display device according to claim 13 or 14,
wherein a distance between the red subpixel first electrode (1^{st} electrode) of the red (R) subpixel and the second electrode (2^{nd} electrode) in the red (R) subpixel is set to be λ / 2n, and
a distance between the first electrode (1^{st} electrode) of the green (G) subpixel and the second electrode (2^{nd} electrode) in the green (G) subpixel is set to be twice λ / 2n,
where λ is a wavelength of light emitted by the respective subpixel, and n is a refractive index of an organic layer between the first electrode (1^{st} electrode) and the second electrode (2^{nd} electrode) in the respective subpixel.
